# EUROPEAN PATENT APPLICATION

(11) **EP 2 738 790 A1**
(43) Date of publication of application: **04.06.2014**
(21) Application number: 12380053.4
(22) Date of filing: 28.11.2012
(51) Int. Cl.: H01L 21/02, H01L 21/316

(54) **Procedure for preparing one single barrier and/or dielectric layer or multilayer on a substrate and device for the implementation thereof**

(71) Applicant: Abengoa Solar New Technologies, S.A., 41014 Sevilla (ES)
(72) Inventor: Gil Rostra, Jorge, 41092 Sevilla (ES); Rico Gavira, Victor, 41092 Sevilla (ES); Yubero Valencia, Francisco, 41092 Sevilla (ES); Espinos Manzorro, Juan Pedro, 41092 Sevilla (ES); Rodriguez Gonzales-Elipe, Agustin, 41092 Sevilla (ES); Sanchez Cortezon, Emilio, 41014 Sevilla (ES); Delgado Sanchez, Jose Maria, 41014 Sevilla (ES)
(74) Representative: Garcia-Cabrerizo y del Santo, Pedro Maria

(57) **Abstract**

The present invention relates to the procedure for the preparation of barrier and/or dielectric layers on a substrate, characterized in that it comprises the following stages: (a) cleaning the substrate, (b) placing the substrate on a sample holder and the introduction thereof into a vacuum chamber, (c) dosage of said vacuum chamber with an inert gas and a reactive gas, (d) injection into the vacuum chamber of a volatile precursor that has at least one cation of the compound to be deposited, (e) activation of a radio frequency source and activation of at least one magnetron, (f) decomposition of the volatile precursor using plasma, the reaction between the cation of the volatile precursor and the reactive gas occurring at the same time that the reaction between the reactive gas contained in the plasma and the cation from the target by sputtering takes place, thus leading to the deposition of the film onto the substrate. The device for carrying out said method is also object of the invention.

## Description

### TECHNICAL SECTOR OF THE INVENTION

The present invention falls within the field of preparation of thin films having a barrier/dielectric layer effect, with a wide variety of uses. The invention proposed can be especially used in the microelectronic and optoelectronic sectors, primarily in the manufacturing of large-area devices. Within the optoelectronic field, a clear example of usage of the present invention can be found in the design and manufacturing of thin-film photovoltaic solar modules on metal substrates, where the concept of monolithic integration is put into effect for the interconnection of solar cells, and where the development of thin dielectric layers that in addition act as diffusion barriers, is indispensable.

Generally, the present invention can be used in electronics where it is necessary to electrically insulate two metals by means of an intermediate layer that exerts electric insulation and diffusion barrier functions.

### BACKGROUND OF THE INVENTION

The development of dielectric and barrier layers for electrically insulating metal substrates or semiconductors is a problem of great significance that determines both the development of electronic circuits smaller in size, as well as, on another level, the industrial development of optoelectronic uses on these types of materials. A typical case in this sense is the development of photovoltaic modules based on thin films grown on metal substrates. Indeed, currently there are no thin-film commercial photovoltaic modules on metal substrates that make use of the monolithic integration technique for the interconnection of solar cells. One of the reasons for this is the lack of dielectric materials that achieve effective insulation of the metal substrate of the rear electrode of the cell. In these conditions, monolithic integration cannot be made on a metal substrate due to the development of short circuits between the metal substrate and said rear electrode of the cell. As an alternative to monolithic integration, a connection process of the cells by means of the conventional method known as "tapping" is used, where contact is a made by welding two cells, joining the positive pole and the negative pole of both by means of an electrical conductor. However, this process does not make use of the active area of the module; it limits the penetration of the product within the architectural market on account of aesthetic aspects, and does not differentiate the product from the conventional Silicio technology, in addition to involving high costs.

The existing commercial products of nowadays, are based on thin-film metal substrates (usually steel, titanium or another malleable metal in tape form), are usually protected by a metal layer of small thickness (for example, chromium or other metals with thicknesses in the range of tens of microns). Said layer (barrier layer) is incorporated to prevent metal impurities from the substrate to diffuse towards the semiconductor and alter its performance, either because they can modify the characteristics thereof or, simply, for producing an undesired increase in recombination of the electron-hole carriers and/or pairs. However, these metal layers do not have any function of electric insulation preventing the charge migration to the metal substrate; therefore, it is not possible to establish a monolithic integration of the cells in the module. In these products, the interconnection of cells is performed by conventional welding methods such as mono or polycrystalline silicon technology, which implies disadvantages as a result of having less useful area in the module, as are less power in the module (reduced efficiency), lower production rate, implying higher selling costs of the final product and, furthermore, that does not result in an appealing product for the BIPV (Building Integrate Photovoltaic) market.

Consequently, the role of the thin metal layers is to prevent impurities from the substrate diffusing to the semiconductor. However, achieving this function of a barrier against the diffusing of chemical elements, simultaneously with the function of effective electrical insulation, which prevents dielectric breakdown therethrough, requires the use of materials that are dielectric in nature. Furthermore, to optimize this function in practice, it can be verified that such layers require additional features that are hard to obtain and that support the grounds of this proposed patent: a barrier and dielectric layer with dense microstructure, and that for thicknesses of approximately several microns, do not suffer processes of mechanical stress that can lead to its delamination. These characteristics of the layers are necessary, for example in solar cells comprising metal substrates, since these layers must be capable of blocking the pathway of the charge carriers from the rear electrode of the cell towards the metal substrate, even in areas thereof characterized by peaks, grains, or other elements typical of the intrinsic roughness of the metal where, on a local scale, the density of electric field can be very high.

The dielectric breakdown processes are produced as a result of highly localized effects through certain areas of the dielectric barrier, where, due to multiple factors such as; a reduced local thickness of the layer; the existence of certain electrically favorable pathways, as a result of a certain interconnected porosity; the existence of defects or grain boundaries; the accumulation of impurities and/or OH groups or adsorbed water molecules in the case of oxides, etc., electron cascades can be produced, that electrically pierce the material and generate permanent pathways with negligible electrical resistance which connect the metal substrate to the semiconductor.

To mitigate the occurrence of such dielectric "breakages" several strategies are considered:
- increasing the thickness of the layer: the greater the thickness, the lower the probability that the charge reaches the metal substrate thus maintaining the global electrical insulation,
- increasing the density and conformality of the layer: the denser the microstructure, the lower the probability that the carrier finds "open pathways" that facilitate the diffusing thereof, whether punctual defects (impurities) or surface defects (grain boundaries). A good conformality on the surface roughness of the substrate would achieve that not only the dielectric layer have the average thickness necessary for preventing dielectric breakdown, but also locally, above the tips or apices of the most prominent elements of the surface roughness of the substrate, the minimum thickness necessary to prevent the electric field therein from causing the local dielectric breakdown would be achieved.

Layers with dielectric barrier function have been attempted to be prepared using a variety of methods, including wet chemical methods (sol-gel, etc.), as well as other dry methods implementing processing techniques that operate in environments requiring vacuum. In the first case (wet chemical methods), the methods used require several stages and significantly long process time periods (reaction, drying, depositing, calcination, etc.), with a considerable difficulty to achieve layers of several microns without chemical or microstructural defects (cracks, delaminations, etc.). Furthermore, from the viewpoint of its integration in industrial processes that make main use of vacuum deposition processes, they present the crucial limitation of requiring a separate processing line.

Other techniques commonly used for the formation of the barrier or dielectric layers are those of vacuum processing, among which can be found Physical Vapor Deposition (PVD), using sputtering of a target or several targets, and the Chemical Vapor Deposition (CVD). However, some problems of these techniques relate to the fact that it is not easy to achieve layer thicknesses greater than one micron in reasonable time periods and that, generally, they do not result in compact, conformal layers, without structural defects on rough conductive substrates that can ensure high breakage voltages.

Within the CVD techniques, the Plasma Enhanced Chemical Vapor Deposition (PECVD) is also used to form layers or coatings. The classical PECVD technique consists in the decomposition of volatile metal precursor using plasma, which induces deposition on a substrate of a layer of oxide, nitride, oxynitrides, carbide, etc., depending on the nature of the plasma itself. As such, it is used for a large number of industrial processes where a good conformality and the quality of not being able to heat the substrates are two essential requirements. It should be pointed out that this technique can also operate at substrate temperatures higher than room temperature. The main inconveniences of the PECVD technique is the high investment in equipment (a chamber or adhoc system with its own sources, treatment/additional deposition systems, etc. are required) together with the complexity of controlling the PECVD processes. Another noteworthy inconvenience of this technique is that, in the case of very thick layers, the amount of precursor to be used is very high, with the environmental implications that it poses.

On the other hand, the sputtering technique, commonly used for large scale industrial processes, is not totally appropriate per se for making barrier and dielectric layers, as it generally does not prevent the incorporation of local defects, which are a clear source for generating specific pathways for the electron cascades that are produced in the dielectric breakdowns. Thus, usually the dielectric layers prepared by sputtering require very high thicknesses to achieve an efficient insulation. In practice, this approach is precluded for economic and time reasons and because layers so thick have a strong tendency to delaminate.

Due to the inconveniences that the existing techniques present upon obtaining barrier and/or dielectric layers with a thickness of approximately microns, that are conformal, dense and have no structural defects so that they carry out their function optimally and effectively, the present invention proposes a procedure based on the combination of the PECVD and PVD techniques for the development of structures of dielectric layers or multilayers, barrier layers and leveling layers, that resolve the inconveniences of the conventional techniques. Having a dielectric layer allows for the electric insulation of the substrate, a barrier layer prevents the diffusing of chemical elements from the substrate, and the fact of being leveling means that it eliminates or minimizes the effects of the superficial morphological defects of the sample, shielding the effects of waves and peaks in the topology of the substrate. Due to the optimal characteristics of the layers deposited by the procedure of the present invention, said procedure has a variety of uses, including, as previously mentioned, in the optoelectronic field and manufacturing of solar cells that comprise metal substrates, since it allows to obtain dielectric layers, avoiding the electric continuity between the metal substrate and the rear electrode of the solar cell. In addition, the layer obtained through the claimed procedure allows preventing diffusion of chemical elements from the substrate towards the semiconductor, exerting a leveling effect, which prevents defects in the topology of the substrate (peaks and other protuberances) from having an undesirable effect on the performance of the device on which the deposition is carried out. However, this procedure can also be applied to non-metal substrates or non conductors in which barrier, dielectric, and/or leveling layers must be deposited.

Next are examples of some documents of state of the art in which coating layers or procedures for the depositing thereof are disclosed:
- Patent US20100243047(A1): this document discloses a layer that acts as a barrier to prevent the diffusion of sodium from a (glass) substrate to provide accurate control in its content in the module by doping with external sources.
- "Diffusion barriers for CIGS solar cells on metallic substrates", K. Herz et al, Thin Solid Films 431-432, 392 (2003)
- "Cu(In,Ga)Se2 solar cells on stainless-steel substrates covered with ZnO diffusion barriers", C.Y. Shi et al, Solar Energy Materials and Solar Cells, 93(5), 654 (2009)
- "Dielectric barriers for flexible CIGS solar modules", K. Herz et al, Thin Solid Films 403-404, 382 (2002).
- "Technological aspects of flexible CIGS solar cells and modules", F Kessler et al, Solar Energy 77(6), 685 (2004)

In these state of the art publications, the layers deposited act as a barrier, but are not dielectric layers. Moreover, they do not use the combined procedure of the present invention which allows obtaining barrier and/or dielectric layers that are compact, conformal and without structural defects on the rough conductor substrates, ensuring high breakage voltages.

### DESCRIPTION OF THE INVENTION

The depositing of barrier layers with characteristics that allow obtaining a good dielectric layer function requires the layer to have a thickness of approximately microns, a dense (compact), as well as conformal microstructure, on the rough surface of the conventional metal substrates. A "leveling" effect of the superficial topography could also be convenient in order to achieve a flatter growth of the whole cell. A deposition method of thin layer or multilayer is proposed, in order to achieve these characteristics through a combined process based on the use of plasmas to simultaneously cause the deposition, through the known techniques PECVD and PVD (sputtering). The process of sputtering is a physical process whereby atoms are vaporized from a solid material called "target" or "cathode" by bombarding the target with energetic ions; the ions for the sputtering process are obtained from plasma, which is generated inside the sputtering equipment. The PECVD technique consists, as previously mentioned, in the decomposition by means of plasma from a volatile metal precursor, which causes the deposition on a substrate of a layer of oxide, nitride, carbide, etc., depending on the nature of the plasma itself.

Implementing the PECVD and PVD techniques together (with independent control of both sources of plasma), not only modification of the microstructural properties of homogeneous single layers is achieved, but also the creation of multilayers formed by depositing several layers in different process conditions and, thus, adapted to all the possible surface conditions and topologies of the substrates used. Therefore, the procedure of the present invention to obtain barrier and/or dielectric layers on a substrate comprises at least one stage in which the PVD (sputtering) and PECVD deposition techniques are used simultaneously, from a volatile precursor compound and at least one cathode or target containing an element of the compound to be deposited.

The formation of the coating or layer on a substrate implementing the PVD and PECVD techniques simultaneously is performed in a single vacuum chamber, activating at least one magnetron that generates plasma and directly injecting a volatile precursor in the plasma area. Additionally, the effectiveness of the plasma formation process can be enhanced, further improving the characteristics of the deposited layers, assisting the growth thereof by applying RF (radio frequency) polarization to the substrate. The plasma can be maintained by the activation of the magnetron, the RF polarization of the substrate, or by the combined action of the magnetron and the RF polarization. In either case, the generated plasma enables the PVD and PECVD process to be produced simultaneously.

The deposition of material from the target or cathode (PVD process) will only take place if the volatile precursor is not injected into the chamber and if the corresponding magnetron is activated, and only the deposition of material from the volatile precursor (PECVD process) will take place if the magnetron is not activated and if the volatile precursor is injected into the chamber.

The optimization of the criteria on conformality, thickness, decrease in the deposition time in order to obtain critical thickness and increase of the dielectric breakdown voltages are achieved by defining specific processing protocols of the layers. Said protocols refer to the way in which the various processes can be combined, that is, a multilayer is achieved by the appropriate combination of the PVD, or PECVD processes, or by combination of both simultaneously, as well as managing the substrate temperature as an additional control parameter to optimize the dielectric breakdown properties and mechanical stability of the final structure.

One possibility for depositing a dielectric multilayer with optimized structure consists in depositing a first conformal layer, whereby the PECVD process is selected, followed by a simultaneous combined process of PVD deposition in addition to PECVD deposition, which will increase the deposition speed with the generation of a somewhat less homogeneous layer, but in which a less compact, pillar structure does not develop, typical of pure PVD processes, which are not suitable for preventing the dielectric breakdown, and finally, being able or not to finish with a pure PVD process. This alternation of processes or another different one would be possible implementing the claimed technology, the temperature being another process parameter that optimizes the properties of the assembly. Variations in thickness, composition, relative intensity of the PVD process against that of PECVD, order and number of the different layers, temperatures of the substrate, etc., would be optimizable and adjustable variables for each specific case.

It should be noted that the claimed process allows both the deposition of a layer of a compound with one or several metal elements. In the first case, both the target of the magnetron and the volatile compound to be broken down by the plasma would contain the same metal element. In the second case, the target would contain a metal element different to that of the volatile precursor, making it different metal elements.

The process of the present invention which includes the deposition of a layer or multilayer implementing PVD and PECVD techniques simultaneously comprises the following stages:
- Cleaning of substrates: which comprises washing and drying thereof. The washing can be carried out with water, water and acetone, water with detergent, organic solvents, following a number of sequences, according to circumstances and that can be assisted by applying an ultrasonic bath.
- Placing the substrate in the sample holder or substrate carrier (it is the base on which the substrate is fixed or positioned) and inserting it into the vacuum chamber. If necessary, the substrates can be dried with nitrogen before introducing them into the vacuum chamber where the PVD and PECVD processes are performed. Depending on the type and size of the substrates, these should be fixed or placed in direct contact with the heating systems and application systems of the RF field so that it can be effectively applied to the surface where the layer is being deposited.
- Beginning of the PECVD and PVD processes simultaneously, for this, the following stages will be carried out:
   - injecting into the vacuum chamber a volatile precursor that has at least one cation of the compound to be deposited. Typical but non-limiting values of the partial pressure of the volatile precursor dosed into the chamber are around 2x10⁻³ mbar, being common values those comprised between 10⁻³ and 10⁻² mbar. Generally the dosage of the precursor is performed by mass flow controllers or dosing valves. The procedure is also compatible with the dosing of two or more volatile precursors, in the case of wanting to obtain mixed composition layers. Depending on the metal element of the compound to be deposited, the volatile precursors used can be organometallic compounds, hydrides, chlorides or combined formulations thereof.
   - dosing in said vacuum chamber with an inert gas and/or a reactive gas. Usually oxygen is used as reactive gas, in the case that the layer to prepare is an oxide or a nitride gas, to prepare nitrides or mixtures thereof, for preparing oxy-nitrides compounds, for example, aluminum oxynitride). Depending on the working conditions only a reactive gas can be used. The dosing thereof is typically performed by mass flow controllers, the typical but non-limiting partial pressure values being around 3x10⁻³ mbar. This stage of inert gas and/or a reactive gas dosing can also be carried out prior to injection of the volatile precursor.
   - activation of a radio frequency source connected to a substrate carrier or an external plasma source coupled to the chamber and activation of at least one magnetron located inside the vacuum chamber, the magnetron being provided with at least one cathode or one target containing the metal element of the compound to be deposited. These processes for activating a radio frequency source and activating at least one magnetron may be simultaneous or successive.
   - decomposition of the volatile precursor or precursors using plasma, the reaction between the volatile precursor or precursors and the reactive gas plasma occurring at the same time that the interaction between the plasma with the cation from the sputtering target takes place, thus leading to deposition of the film on the substrate.

The composition of this film can be simple, containing a single metal cation, in the case of the precursor and target having a single type of metal element, or mixed, in the case that there is more than one target with various metal elements and/or more than one volatile precursor is dosed.

Prior to injection of the volatile precursor, the temperature of the sample holder or fixation system of the substrates should be adjusted to a range between, a room temperature of approximately 20 °C and 500 °C, the speed of rotation thereof at values to around 20 revolutions per minute, in the event that this functionality were implemented in the deposition system, the temperature of the volatile precursor dosing system, the flow of gases and working pressure, must be adjusted.

In the event that one wishes to perform an initial deposition implementing the PECVD technique alone, the magnetron provided with a cathode or target containing the element of the compound to be deposited will not be activated, whereas if one wishes to perform a further stage only by the technique PVD, the volatile precursor would not be inject to the vacuum chamber.

The process is stopped by closing the volatile precursor measurement, turning off the RF power source, turning off the power supply of the magnetron, closing the working gas inlet, turning off the heating and rotation of the sample holder. The samples will be kept in the preparation chamber until a relative cooling is achieved, enough to avoid thermal stresses. Temperatures of approximately 100 °C are usually adequate but not limiting. Once the samples have cooled and their thermal equilibrium reached, they can be removed from the vacuum chamber.

The substrates which can be used for this process may be of metallic or non-metallic nature, such as glass, polymers, ceramic materials, semiconductors, etc., taking into account their thermal stability upon defining the temperature used during the deposition process.

The inert working gases are normally argon, helium or another plasma activator gas such as nitrogen and the reactive gases oxygen, nitrogen or mixtures thereof. Elements such as Si, Al, etc., or compounds such as Si₃Al₂, etc., may be used as a target or cathode.

In the event of wanting to form a dielectric barrier layer based on silicon oxide, in the PVD process, a target of pure silica or lightly doped with aluminum would be used, as in the case of industrial targets (silicon oxide targets could also be used, or mixtures of silicon oxide and aluminum oxide), and a silicon volatile precursor for the PECVD process. Examples of volatile silicon precursors are hexamethyldisiloxane (HMDSO), silicon tetraethoxide (TEOS), other alkoxides, hydrides, chlorides or allyl silanes. The target chosen and the volatile precursor chosen will depend on the desired composition of the layer or multilayer to be formed. Thus, for example, it is possible to have layers of an oxide such as silicon (SiO2), of aluminum, or of a mixed oxide such as the one from aluminum and silicon (AlSiO) or multilayers formed by different composition layers.

By applying the procedure of the present invention based on the simultaneous and/or successive use of the PVD and PECVD techniques, it is possible to obtain layers of controlled thickness on a wide range of values from 100 nanometers to more than one micron, being possible to reach values of several microns.

An optimization of minimum thickness of the layers or multilayer, the suppression of problems related to the mechanical stress thereof, and independent control of the chemical composition along the thickness of the dielectric layers are other advantages of the claimed procedure. The ability to independently control and/or vary the substrate temperature during deposition of the layer(s) provides an additional variable for optimizing the properties of the final multilayer structure.

Generally, at equal thicknesses and compositions, higher dielectric breakdown values are achieved when the PECVD or combined process is performed at high temperatures, generally above 200 °C. The choice of temperature for the process will therefore serve both to that criterion and to the dependence with this parameter of the deposition rate, temperature dependent stress, cost, etc.

It should also be noted that the development of the process claimed herein, also presents several advantages in relation to the decrease of the deposition times and resource optimization from the point of view of an industrializable process, as it is compatible with the same PVD sources used in pure sputtering processes, making it possible to perform the PECVD process by direct RF (radio frequency) polarization of the substrate. This possibility would cheapen and simplify the development of the process, faced to the obvious choice of using an additional plasma source.

The device for obtaining layers or multilayers by deposition implementing the procedure of the present invention comprises a vacuum chamber provided with a vacuum system, consisting of one or several vacuum pumps that allow to achieve the required vacuum for the process within the chamber, it also comprises at least one inlet for inert gas and another for reactive gas, and at least one inlet for the volatile precursor from which the deposition will occur by the PECVD technique. Inside the chamber there is at least one magnetron with a target or cathode containing one element of the compound to deposit from which sputtering or PVD process occurs. Also inside the chamber there is one sample holder which will hold the substrate, said holder being connected to a power source and a temperature controller. The sample holder may be connected to an RF source that will produce and/or reinforce the plasma responsible for the decomposition of the volatile precursor. A plasma source could also be coupled to the chamber. Therefore the chamber integrates the necessary elements to simultaneously perform the PVD and PECVD processes, to form layers or multilayers on a substrate. Optionally, inside the chamber there can be a thickness gauge positioned close to the sample holder to control the thickness of the deposited layer.

### Brief description of the figures

Figure 1. Diagram of the device for performing the deposition process by the simultaneous application of the PVD and PECVD techniques.
Figure 2. SEM image (scanning electron microscopy) having a cross section of a layer of silicon dioxide (SiO₂) prepared according to the procedure described in example 1 of the present invention.
Figure 3. I_V (intensity versus voltage) curves measured at different points of the layer of silicon dioxide (SiO₂) prepared according to the procedure described in example 1 of the present invention, showing a negligible current leakage in all the analyzed points.
Figure 4 shows a cross-sectional SEM micrograph of a layer obtained according to the stages of the process, described in Example 2 of the present invention.
Figure 5 corresponds to breakage curve I-V (voltage versus intensity) of the layer obtained according to the stages of the process, described in Example 2 of the present invention, in which it can be seen how the breaking process takes place at a voltage around 35 V.

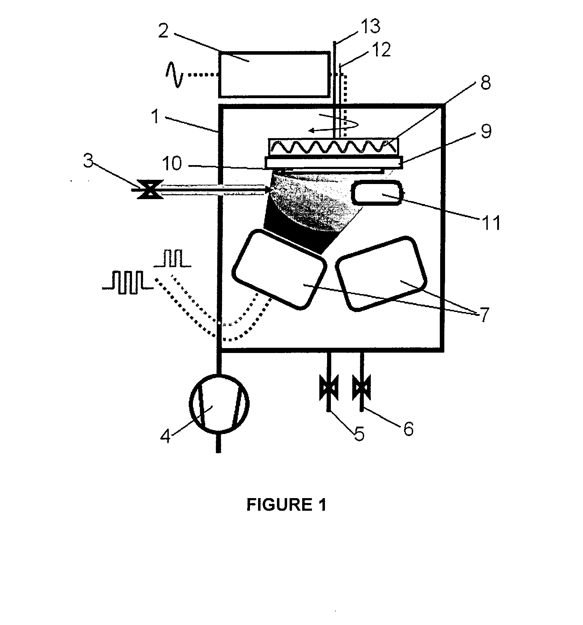

The numerical references that appear in figure 1 refer to the following elements:
1.- Vacuum chamber
2.- Radio frequency source
3.- Volatile precursor inlet
4.- Vacuum system
5.- Inert gas inlet
6.- Reactive gas inlet
7.- Magnetron
8.- Sample holder
9.- Substrate
10.- Deposited layer
11.- Thickness gauge
12.- Thermometer
13.- Power input for the heater

### Detailed description of the invention

Figure 1 shows a diagram of the device for performing the deposition process by means of the simultaneous application of the PVD and PECVD techniques. As it can be seen, the device comprises a vacuum chamber (1) provided with a vacuum system (4) that allows to achieve the necessary vacuum for the process inside the chamber. It also comprises an inert gas inlet (5) and a reactive gas inlet (6), as well as, an inlet for the volatile precursor (3). Inside the chamber there is at least one magnetron (7) with the target containing the metal element of the compound to be deposited, which leads to the sputtering or PVD process. Also inside the chamber (1) there is a sample holder (8), which will hold the substrate (9), said holder (8) being connected to a power input (13) for the heater and a thermometer (12) that controls the temperature. The sample holder is connected to a radio frequency source (2). The chamber is also provided with a thickness gauge (11) for the deposited layer or multilayer (10).

### Example 1:

The following describes in detail an example (Example 1) of the procedure for depositing a layer of silicon dioxide (SiO₂) on a metal substrate from a silicon target placed on the cathode of the magnetron, wherein said process includes a deposition stage implementing the PECVD technique, another deposition stage implementing the PVD and PECVD techniques simultaneously, and a final deposition stage applying the PVD technique (sputtering):
1. The first stage consists in cleaning the substrate (9) by washing it with an aqueous phase, organic or combined solvents, and ultrasound. These are standard pretreatment processes in the industry of coatings on metal substrates and are fully described according to the type of material and the previously performed formation and thermal treatment processes.
2. The clean and dry substrate (9) is placed on a rotating and polarizable sample holder (8) with a diameter of 10 cm, which is introduced into the vacuum chamber. Cleaning is performed through an ion bombardment in RF plasma, directly activating the sample holder in the absence of volatile precursor vapors. A flow of Ar of 20 sccm (cubic centimeters per minute) and the following parameters are set: chamber pressure at 5.0 10⁻³ mbar, at a substrate temperature of 200 °C, a power of the RF source at 50 W, a direct current (DC-Bias) of 250 V. The hold-up time for these conditions is 20 min.
3. Deposition of SiO₂ by the PECVD technique using HMDSO as organic volatile precursor of Si. For this, the volatile precursor is injected into the chamber once the following parameters have been set:
   Flow of Ar at 10 sccm, flow of O₂ at 17.5 sccm, flow of HMDSO (organic precursor of Si) at 4 sccm, chamber pressure at 5.0 10⁻³ mbar, substrate temperature at 200 °C, power of the RF source at 50 W, direct current (DC-Bias) at 250 V. The hold-up time for these conditions is 120 min.
4. Deposition of SiO₂ by implementing the PECVD and PVD techniques, simultaneously.

The conditions of the previous stage are maintained and in addition, the magnetron is activated with a target of Si 3", setting the following parameters: Distance from sample holder to the target at 12 cm, bipolar sputtering power source at 300 W, at a frequency of 80 KHz and 2.5 ms. Execution time under these conditions: 350 min. 5. Deposition of SiO₂ by implementing the PVD technique.

Injection of the volatile precursor ceases, and the following parameters are set: Flow of Ar at 40 sccm, flow of O₂ at 4 sccm, chamber pressure at 5.0 10⁻³ mbar, substrate temperature at 200 °C.

The magnetron with the target of Si 3" remains activated, maintaining the parameters of the magnetron source previously indicated in point 4. The execution time under these conditions is 300 min. 6. End of process: The process is stopped by turning off the RF source, turning off the magnetron source, closing the working gases inlet, and turning off the heating and rotation of the sample holder.

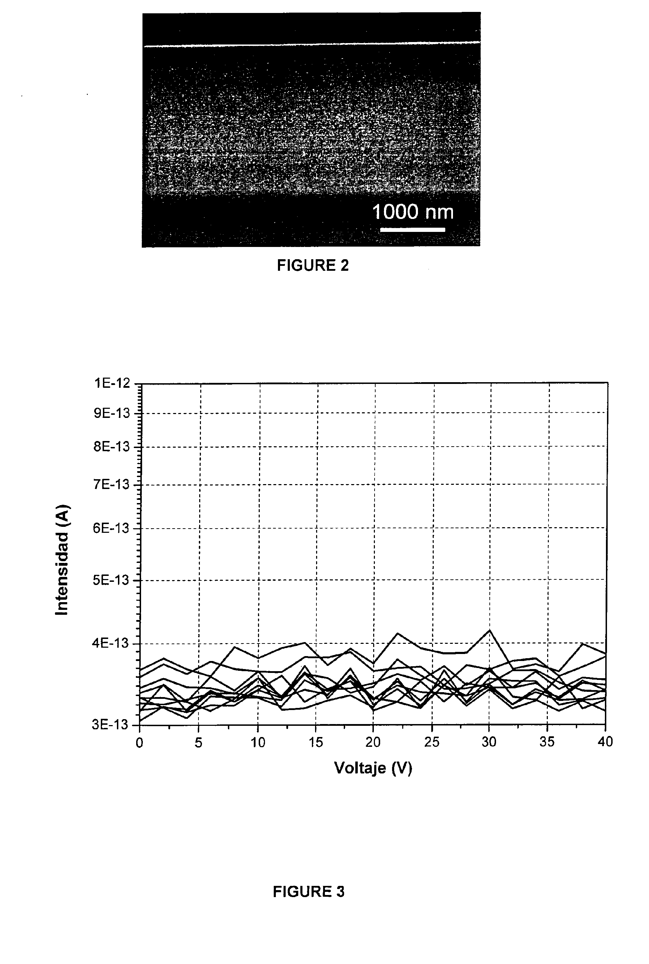

Figure 2 shows a cross-sectional SEM micrograph of a layer obtained according to the stages of process previously described in Example 1 (SiO₂ deposited by PECVD, followed by SiO₂ obtained using PECVD+PVD and a final deposition stage of SiO₂ by the PVD technique, according to the previous protocol). This layer, of 2.4 microns of thickness, has very good electric insulation characteristics as evidenced in Figure 3, where a statistical analysis of I-V (intensity versus voltage is shown) curves, within the range from 0 to 40 V where it can be seen that the current in all the cases is less than 10⁻¹³ amps in the whole range of voltage analyzed, thus demonstrating the total insulation character of the prepared layer.

### Example 2:

The following describes in detail an example (Example 2) of the procedure followed to deposit a multilayer system on a metal substrate, where said process includes a deposition stage of SiO₂ implementing the PECVD technique, another deposition stage of a mixed oxide of aluminum and silicon (AlₓSi_{y}O_{z}), by implementing the PVD and PECVD techniques simultaneously, and a final deposition stage of aluminum oxide (Al₂O₃), implementing the PVD technique (sputtering).
1. The first stage consists in cleaning the substrate (9) by washing it with an aqueous phase, organic or combined solvents, and ultrasound. These are standard pretreatment processes in the industry of coatings on metal substrates and are fully described according to the type of material and the previously performed formation and thermal treatment processes.
2. The clean and dry substrate (9) is placed on a rotating and polarizable sample holder (8) with a diameter of 10 cm, which is introduced into the vacuum chamber. Cleaning is performed through an ion bombardment in RF plasma, directly activating the sample holder in the absence of volatile precursor vapors. A flow of Ar of 20 sccm (cubic centimeters per minute) and the following parameters are set: chamber pressure at 5.0 10⁻³ mbar, at a substrate temperature of 200 °C, a power of the RF source at 50 W, a direct current (DC-Bias) of 250 V. The hold-up time for these conditions is 20 min.
3. Deposition of SiO₂ by the PECVD technique using HMDSO as organic volatile precursor of Si. For this, the volatile precursor is injected into the chamber once the following parameters have been set:
   Flow of Ar at 10 sccm, flow of O₂ at 17.5 sccm, flow of HMDSO (organic precursor of Si) at 4 sccm, chamber pressure at 5.0 10⁻³ mbar, substrate temperature at 200 °C, power of the RF source at 50 W, direct current (DC-Bias) at 250 V. The hold-up time for these conditions is 120 min.
4. Deposition of AlₓSi_{y}O_{z} by implementing the PECVD and PVD techniques, simultaneously.

The conditions of the previous stage are maintained and in addition, the magnetron is activated with a target of Al 3", setting the following parameters: Distance from sample holder to the target at 12 cm, bipolar sputtering power source at 300 W, at a frequency of 80 KHz and 2.5 ms pulse. Execution time under these conditions: 480 min. 5. Deposition of Al₂O₃ by implementing the PVD technique.

Injection of the volatile precursor ceases, and the following parameters are set:
Flow of Ar at 40 sccm, flow of O₂ at 4 sccm, chamber pressure at 5.0 10⁻³ mbar, substrate temperature at 200 °C.

The magnetron with the target of Al 3" remains activated, maintaining the parameters of the magnetron source previously indicated in point 4. The execution time under these conditions is 300 min. 6. End of process: The process is stopped by turning off the RF source, turning off the magnetron source, closing the working gases inlet, and turning off the heating and rotation of the sample holder.

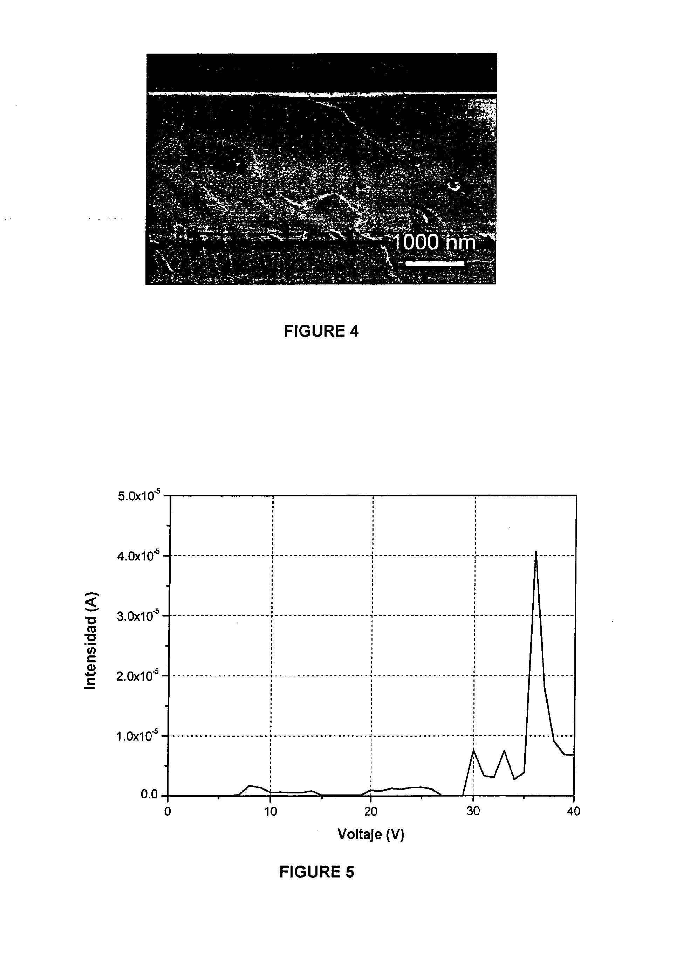

As previously mentioned, Figure 4 shows a cross-sectional SEM micrograph of a layer 2.5 microns thick obtained according to the stages of the process previously described in Example 2 (SiO₂ deposited by PECVD, followed by a mixed oxide layer of AlxSiyOz obtained by PECVD (SiO₂) + PVD (Al₂O₃) and finally, a deposition of Al₂O₃ implementing the PVD technique. Figure 5 corresponds to the breakage curve I-V of this sample, in which it can be see how the breaking process takes place at a voltage around 35V.**

## Claims

1. Procedure for preparing one single barrier and/or dielectric layer or multilayer on a substrate **characterized in that** it comprises the following stages:
(a) cleaning of substrates by washing and drying thereof,
(b) placing the substrate on a simple holder and inserting it into a vacuum chamber,
(c) dosage of said vacuum chamber of at least one inert gas and/or one reactive gas
(d) injection into the vacuum chamber of a volatile precursor that has at least one cation of the compound to be deposited, whereby said injection is performed using mass flow controllers or dosage valves
(e) activation of a radio frequency source connected to a sample holder and activation of at least one magnetron located inside the vacuum chamber the magnetron provided with at least one cathode or one target containing the metal element compound to be deposited,
(f) decomposition of the volatile precursor using plasma, the reaction between the cation of the volatile precursor and the reactive gas occurring at the same time that the reaction between the reactive gas contained in the plasma and the cation from the target by sputtering takes place, thus leading to the deposition of the film onto the substrate.

2. Procedure for obtaining one single barrier and/or dielectric layer or multilayer on a substrate, according to claim 1, **characterized in that** the substrate is a metal, glass, polymer, ceramic material or a semiconductor.

3. Procedure for obtaining one single barrier and/or dielectric layer or multilayer on a substrate, according to claim 1, **characterized in that** the barrier and/or dielectric layer obtained has a thickness from 100 nanometers to various microns.

4. Procedure for obtaining one single barrier and/or dielectric layer or multilayer on a substrate, according to claim 1, **characterized in that** volatile precursor contains a cation of a metal element different to that contained by the target or cathode.

5. Procedure for obtaining one single barrier and/or dielectric layer or multilayer on a substrate, according to claim 1, **characterized in that** the volatile precursor contains a cation of the same metal element as that contained by the target or cathode.

6. Procedure for obtaining one single barrier and/or dielectric layer or multilayer on a substrate, according to claim 1, wherein hexamethyldisiloxane (HMDSO) is used as volatile precursor compound.

7. Procedure for obtaining one single barrier and/or dielectric layer or multilayer on a substrate, according to claim 1 wherein the target of cathode is of silicon, aluminum or silicon oxide and aluminum (AlSiO).

8. Procedure for obtaining barrier and/or dielectric layers on a substrate, according to claim 1, **characterized in that** the reactive gas is oxygen, nitrogen, or a mix of both.

9. Procedure for obtaining barrier and/or dielectric layers on a substrate, according to claim 1, **characterized in that** the inert gas is argon, helium or nitrogen.

10. Procedure for obtaining the barrier and/or dielectric layer on a substrate, according to claim 6, **characterized in that** the layer deposited is of silicon dioxide (SiO2).

11. Procedure for obtaining the barrier and/or dielectric layer on a substrate, according to claim 1, **characterized in that** once the substrate is placed on the sample holder, the temperature of the substrate is set at a room temperature between 20 °C and 500 °C.

12. Barrier and/or dielectric layer or multilayer obtained by the process described in claim 1.

13. Device for performing the procedure of claim 1 **characterized in that** it comprises a vacuum chamber (1) provided with a vacuum system (4), an inert gas inlet (5) and a reactive gas inlet (6), as well as, an inlet for the volatile precursor compound (3) from which the deposition by PECVD is produced; inside the chamber (1) there is at least one magnetron (7) with the target or cathode of the element to be deposited from which the PVD process is produced, it also comprises, inside the chamber (1), a sample holder (8) which holds the substrate (9), said holder (8) being connected to a direct current input (13), to a radio frequency source (2), and to a thermometer (12) that controls the temperature.

14. Device according to claim 13 **characterized in that** it comprises a thickness gauge (11) for the deposited layer (10) located close to the sample holder.
